(19)

Europäisches Patentamt
European Patent Office
Office européen des brevets

(11) EP 4 439 639 A1

(12) EUROPEAN PATENT APPLICATION
published in accordance with Art. 153(4) EPC

(43) Date of publication:
02.10.2024 Bulletin 2024/40

(21) Application number: 22968741.3

(22) Date of filing: 29.12.2022

(51) International Patent Classification (IPC):
H01L 21/762 (2006.01)    H01L 21/306 (2006.01)
H01L 21/3105 (2006.01)

(52) Cooperative Patent Classification (CPC):
Y02P 70/50

(86) International application number:
PCT/CN2022/143559

(87) International publication number:
WO 2024/130780 (27.06.2024 Gazette 2024/26)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 21.12.2022 CN 202211652486

(71) Applicant: Zhonghuan Advanced Semiconductor
Technology Co., Ltd.
Wuxi, Jiangsu 214203 (CN)

(72) Inventors:
• MA, Qianzhi
Wuxi, Jiangsu 214203 (CN)
• SUN, Chenguang
Wuxi, Jiangsu 214203 (CN)
• WANG, Yanjun
Wuxi, Jiangsu 214203 (CN)

• YAO, Zuying
Wuxi, Jiangsu 214203 (CN)
• MA, Kun
Wuxi, Jiangsu 214203 (CN)
• ZHANG, Yuhang
Wuxi, Jiangsu 214203 (CN)
• ZHANG, Qi
Wuxi, Jiangsu 214203 (CN)
• WEI, Qiwang
Wuxi, Jiangsu 214203 (CN)
• LUO, Chaoyang
Wuxi, Jiangsu 214203 (CN)
• GU, Haiyun
Wuxi, Jiangsu 214203 (CN)
• LI, Zhicai
Wuxi, Jiangsu 214203 (CN)

(74) Representative: Herrero & Asociados, S.L.
Edificio Aqua - Agustín de Foxá, 4-10
28036 Madrid (ES)

(54) SEMICONDUCTOR MATERIAL, PREPARATION METHOD, AND SEMICONDUCTOR DEVICE

(57) Disclose a semiconductor material, preparation method, and semiconductor device, the semiconductor material comprises a first substrate, a first oxide layer, and a top silicon layer which are in a stacked configuration; the first oxide layer is located on the substrate, and the top silicon layer is located on one side of the first oxide layer away from the first substrate; wherein, the first oxide layer has an average thickness $H_1$ along the first direction, the top silicon layer has an average thickness $H_2$ along the first direction, satisfying: $0.01 \leq H_2/H_1 \leq 100$, and $0.01\,\mu m \leq H_1 \leq 5\,\mu m$, $0.01\,\mu m \leq H_2 \leq 0.5\,\mu m$. The thickness of the top silicon layer of the semiconductor material in this application is less than 500nm, and the deviation in the thickness fluctuation of the top silicon layer is less than $\pm 10$nm by employing a selective polishing process, which helps to improve the thickness uniformity of the top silicon layer on the surface of the semiconductor material.

FIG.1

EP 4 439 639 A1

## Description

This application claims priority for a Chinese patent application submitted to the Chinese Patent Office on December 27, 2022, with application number 202211652486.8 and entitled "A SEMICONDUCTOR MATERIAL, PREPARATION METHOD, AND SEMICONDUCTOR DEVICE", the disclosures of which are incorporated by reference in this application.

## TECHNICAL FIELD

This application belongs to the technical field of semiconductor materials, specifically relating to a semiconductor material, preparation method, and semiconductor device.

## BACKGROUND

As an engineering substrate wafer, silicon-on-insulator substrate is a semiconductor material obtained by introducing a uniformly distributed oxide layer on top of conventional wafers. The semiconductor material has a sandwich structure, including a top silicon layer, a buried oxide layer, and a supporting substrate which are in a stacked configuration. For semiconductor materials applied in partially depleted devices, the thickness of the top silicon layer directly affects the electrical properties of the device, such as voltage resistance and conduction resistance. Therefore, how to prepare a thinner and more uniformly varying thickness of the top silicon layer in semiconductor materials is an urgent problem that needs to be solved.

## TECHNICAL PROBLEM

This application provides a semiconductor material, preparation method, and semiconductor device, aiming to solve the problem of poor device performance caused by the thick and uneven thickness variation of the top silicon layer in the semiconductor material.

## TECHNICAL SOLUTION

Firstly, a semiconductor material of the present application comprises a first substrate, a first oxide layer, and a top silicon layer which are in a stacked configuration; the first oxide layer is located on the substrate, and the top silicon layer is located on one side of the first oxide layer away from the first substrate;

wherein, the first oxide layer has an average thickness $H_1$ along the first direction, the top silicon layer has an average thickness $H_2$ along the first direction, satisfying:

$0.01 \leq H_2/H_1 \leq 100$, and $0.01\mu m \leq H_1 \leq 5\mu m$, $0.01\mu m \leq H_2 \leq 0.5\mu m$.

In some embodiments, the top silicon layer comprises a first surface and a second surface arranged facing away from each other along a first direction, the first oxide layer is located on the second surface, the first surface and the second surface have a minimum thickness $H_{min}$ and a maximum thickness $H_{max}$ therebetween along the first direction, satisfying:

$$0.1\% \leq (H_{max}-H_{min})/(H_{max}+H_{min}) \leq 5\%, \text{ and } H_{max} > H_2, H_{min} < H_2.$$

In some embodiments, the top silicon layer satisfies:

$$0.05\mu m \leq H_{max} \leq 0.5\mu m;$$

and/or,

$$0.03\mu m \leq H_{min} \leq 0.3\mu m.$$

Secondly, the present application also provides a preparation method for semiconductor materials, comprising

the following steps:

provide a first substrate and a second substrate respectively, forming a first oxide layer on the first substrate and/or on the second substrate;

performing oxygen ion implantation on the second substrate so that the second substrate comprises a first separation layer, a second oxide layer, and a second separation layer which are in a stacked configuration along the first direction;

bonding the second substrate to the first substrate so that the first oxide layer is located between the first substrate and the second substrate;

thinning the second separation layer, the second oxide layer, and a portion of the first separation layer to form a top silicon layer on the first oxide layer, and prepare semiconductor materials.

In some embodiments, in case where the first oxide layer is located on the second substrate and forming the first oxide layer on the second substrate, the step of performing oxygen ion implantation on the second substrate comprises performing oxygen ion implantation from one side of the second substrate where the first oxide layer is located, the implantated oxygen ions enter the second substrate through the first oxide layer.

In some embodiments, thinning the second separation layer, the second oxide layer, and a portion of the first separation layer comprises:

performing a first chemical mechanical polishing on the second separation layer to expose the second oxide layer;

performing a second chemical mechanical polishing on the second oxide layer to expose the first separation layer;

performing a third chemical mechanical polishing on the portion of the first separation layer to form the top silicon layer.

In some embodiments, the first chemical mechanical polishing employs an alkaline slurry with a pH value ranging from 11 to 13; and/or,

the second chemical mechanical polishing employs an acidic slurry with a pH value ranging from 3 to 5; and/or,

the third chemical mechanical polishing employs an alkaline slurry with a pH value ranging from 10 to 12.

In some embodiments, the polishing temperature for the first chemical mechanical polishing ranges from 20°C to 40°C, the polishing removal rate ranges from $0.5\mu m/min$ to $1\mu m/min$; and/or,

the polishing temperature for the second chemical mechanical polishing ranges from 20°C to 40°C, the polishing removal rate ranges from $0.1\mu m/min$ to $0.6\mu m/min$; and/or,

the polishing temperature for the third chemical mechanical polishing ranges from 20°C to 40°C, the polishing removal rate ranges from 60nm/min to 120nm/min.

In some embodiments, before the step of performing a first chemical mechanical polishing on the second separation layer to expose the second oxide layer, further comprising: performing mechanical grinding on the second separation layer, and after the mechanical grinding, the remaining thickness of the second separation layer ranges from $4\mu m$ to $10\mu m$.

In some embodiments, before the step of performing mechanical grinding on the second separation layer, further comprising performing annealing treatment on the second substrate and the first substrate, the temperature of the annealing treatment ranges from 1320°C to 1380°C, and the annealing treatment lasts from 6 to 8hours.

In some embodiments, during the oxygen ion implantation, the energy of the oxygen ion implantation ranges from 100keV to 500keV, the dose of implantation ranges from $7E16cm^{-2}$ to $2E19cm^{-2}$, the angle of oxygen ion implantation ranges from 6° to 8°, the ion implantation temperature is greater than or equal to 300°C, and the oxygen ion beam current is greater than or equal to 10mA.

In some embodiments, the first oxide layer has an average thickness $H_1$ along the first direction, the top silicon layer has an average thickness $H_2$ along the first direction, satisfying:

$$0.01 \leq H_2/H_1 \leq 100, \text{ and } 0.01\mu m \leq H_1 \leq 5\mu m, 0.01\mu m \leq H_2 \leq 0.5\mu m.$$

In some embodiments, the second oxide layer has an average thickness $H_3$ along the first direction, the distance between the second oxide layer and the first oxide layer in the first direction is H, the size the first separation layer is thinned in the first direction is $H_0$, satisfying:

$$H_2+H_0 \leq H, \text{ and } 100nm \leq H_3 \leq 400nm, 50nm \leq H_0 \leq 300nm.$$

In some embodiments, the material of the first separation layer and the second separation layer is silicon, the material of the second oxide layer is silica.

Thirdly, this application also provides a semiconductor device, the semiconductor device comprises the semiconductor material; or the semiconductor device comprises a semiconductor material obtained by the preparation method.

## BENEFICIAL EFFECTS

Compared to existing technology, a semiconductor material of the present application comprises a first substrate, a first oxide layer, and a top silicon layer which are in a stacked configuration; the first oxide layer is located on the substrate, and the top silicon layer is located on one side of the first oxide layer away from the first substrate; wherein, the first oxide layer has an average thickness $H_1$ along the first direction, the top silicon layer has an average thickness $H_2$ along the first direction, satisfying: $0.01 \leq H_2/H_1 \leq 100$, and $0.01 \mu m \leq H_1 \leq 5\mu m$, $0.01\mu m \leq H_2 \leq 0.5\mu m$. The thickness of the top silicon layer of the semiconductor material in this application is less than 500nm, and the deviation in the thickness fluctuation of the top silicon layer is less than $\pm 10nm$ by employing a selective polishing process, which helps to improve the thickness uniformity of the top silicon layer on the surface of the semiconductor material.

A preparation method for semiconductor materials of the present application comprises the following steps: providing a first substrate and a second substrate respectively, forming a first oxide layer on the first substrate and/or on the second substrate; performing oxygen ion implantation on the second substrate so that the second substrate comprises a first separation layer, a second oxide layer, and a second separation layer which are in a stacked configuration along the first direction; bonding the second substrate to the first substrate so that the first oxide layer is located between the first substrate and the second substrate; thinning the second separation layer, the second oxide layer, and a portion of the first separation layer to form a top silicon layer on the first oxide layer, and prepare semiconductor materials. The preparation method of this application achieves an automatic polishing stop process by performing at least three polishing and thinning processes on the second separation layer, the second oxide layer, and the first separation layer. This significantly reduces the occurrence of errors during polishing. The second oxide layer formed by oxygen ion implantation can completely eliminate the errors caused by the first and second polishing, improving the efficiency of the preparation process. It also simplifies the preparation of the top silicon layer, as it only requires consideration of polishing the first separation layer. This significantly enhances the thickness uniformity of the top silicon layer, ensuring the preparation of semiconductor materials with a top silicon layer thickness of less than 500nm.

## BRIEF DESCRIPTION OF THE DRAWINGS

FIG.1 is a schematic diagram of the structure of a semiconductor material provided in the present embodiment of the application;

FIG.2 is a schematic diagram of the structure of the first substrate provided in the present embodiment of the application;

FIG.3 is a schematic diagram of the structure of the second substrate provided in the present embodiment of the application;

FIG.4 is a schematic diagram of the structure of the second substrate after oxygen ion implantation provided in the present embodiment of the application;

FIG.5 is a schematic diagram of the structure for bonding the second substrate to the first substrate provided in the present embodiment of the application;

FIG.6 is a schematic diagram of the structure after performing mechanical grinding on the first substrate provided in the present embodiment of the application;

FIG.7 is a schematic diagram of the structure after performing a first chemical mechanical polishing provided in the present embodiment of the application;

FIG.8 is a schematic diagram of the structure after performing a second chemical mechanical polishing provided in the present embodiment of the application;

FIG.9 is a magnified view of the area marked A in FIG.1;

FIG. 10 is a magnified view of the area marked B in FIG.4;

FIG.11 is a magnified view of the area marked C in FIG.8;

FIG.12 is a schematic diagram of the structure of another first substrate provided in the present embodiment of the application;
FIG.13 is a schematic diagram of the structure of another second substrate provided in the present embodiment of the application;
FIG. 14 is another schematic diagram of the structure of the second substrate after oxygen ion implantation provided in the present embodiment of the application;

Figure markings, 101- first substrate, 102- first oxide layer, 103- top silicon layer,104- second substrate, 1031- first surface, 1032- second surface, 1041- first separation layer, 1042- second oxide layer, 1043- second separation layer.

## IMPLEMENTATION OF THE PRESENT INVENTION

This application provide a semiconductor material, preparation method, and semiconductor device, to make the purpose, technical solution, and effects of this application clearer, the following will refer to the attached drawings and provide further detailed explanations of this application with examples of implementation. It should be understood that the specific embodiments described here are only intended to explain the present application and are not intended to limit the present application.

As an engineering substrate wafer, silicon-on-insulator substrate is a semiconductor material with a sandwich structure, which introduces a uniformly distributed oxide layer called a buried oxide layer through unique technical means on the basis of conventional polished wafer, and becomes the top device silicon layer/ buried oxide layer/ supporting substrate. Silicon-on-insulator substrates have advantages that cannot be compared to bulk silicon: it enables complete physical isolation of components in integrated circuits, and eliminate parasitic latch-up effects found in bulk silicon CMOS circuits. It is highly regarded due to its significant advantages in power consumption, operating speed, radiation resistance, and device integration. In recent years, with the continuous progress of process technology, there has been rapid development in the preparation of silicon-on-insulator substrates. The materials of silicon-on-insulator substrates can be classified into two main categories based on the thickness of the top device silicon layer: thin-film silicon-on-insulator (the top layer silicon is usually less than $1\mu m$) and thick-film silicon-on-insulator (the top layer silicon is usually greater than $1\mu m$). These materials find widespread applications in products such as RF front-end devices, power devices, image processors, and microelectromechanical systems.

Currently, the preparation techniques for silicon-on-insulator substrates can be categorized into several methods based on the requirements of product application and material specifications, such as the thickness of the top silicon layer and buried oxide layer. These methods include oxygen implantation isolation technology, direct bonding and thinning technology, and smart peeling technology assisted by hydrogen ion implantation. The silicon wafers prepared using oxygen implantation isolation technology exhibit highly uniform top silicon thickness and buried oxide layer thickness. Due to the limitations of the oxygen ion implantation process, the device silicon layer thickness cannot exceed 300nm, and the buried oxide layer thickness cannot exceed 240nm. And in the buried oxide layer, it is often observed that there are discontinuous silicon island defects. This results in a significantly lower breakdown voltage compared to conventional thermal oxidation, thereby limiting the application and technological development of oxygen implantation isolation technology. The intelligent peeling technology, characterized by mature processes, excellent device layer uniformity, and low manufacturing costs, has become the mainstream fabrication technique for insulated silicon substrate materials. However, due to strict technological patent protection, only a few manufacturers are authorized to use this technology for production. Direct wafer bonding and thinning technology, characterized by its simple process and low cost, is limited by the thinning process, making it challenging to achieve precise control over the uniformity of the device silicon layer thickness.

The applicant has discovered that in existing polishing processes, the sequential order of polishing can cause thickness variations between the central and edge regions of the polished surface. As the polishing depth increases and the thickness of the top silicon layer 103 decreases, these thickness variations become more noticeable. This poses a challenge to achieve thickness uniformity when using the polishing process for the preparation of the top silicon layer 103. Therefore, finding a solution to reduce the thickness non-uniformity of the top silicon layer 103 while ensuring a thinner thickness has become an urgent problem that needs to be addressed.

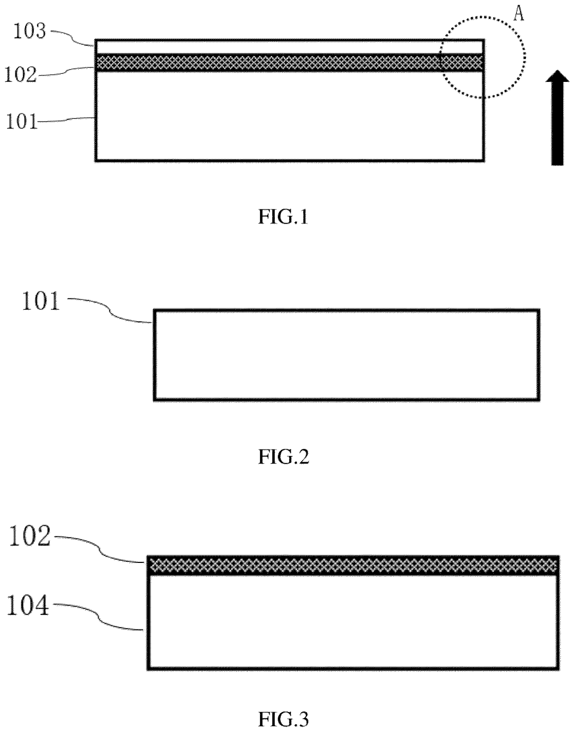

As shown in FIG.1, this application provides a semiconductor material which comprises a first substrate 101, a first oxide layer 102, and a top silicon layer 103 which are in a stacked configuration, the first oxide layer 102 is located on the substrate, and the top silicon layer 103 is located on one side of the first oxide layer 102 away from the first substrate101; wherein, the first oxide layer 102 has an average thickness $H_1$ along the first direction, the top silicon layer 103 has an average thickness $H_2$ along the first direction, satisfying: $0.01 \leq H_2/H_1 \leq 100$, and $0.01\mu m \leq H_1 \leq 5\mu m$, $0.01\mu m \leq H_2 \leq 0.5\mu m$.

In some embodiments, the thickness of the top silicon layer 103 of the semiconductor material in this application is less than 500nm, and the deviation in the thickness fluctuation of the top silicon layer 103 is less than $\pm 10$nm by employing a selective polishing process, which helps to improve the thickness uniformity of the top silicon layer 103 on the surface of the semiconductor material. Wherein the first direction specifically refers to the direction indicated by the arrow in FIG.1, it can be understood that the first direction refers to the thickness direction of the first oxide layer 102 and the top silicon layer 103 respectively; the average thickness can be understood as the calculated value of (maximum thickness+minimum thickness)/2.

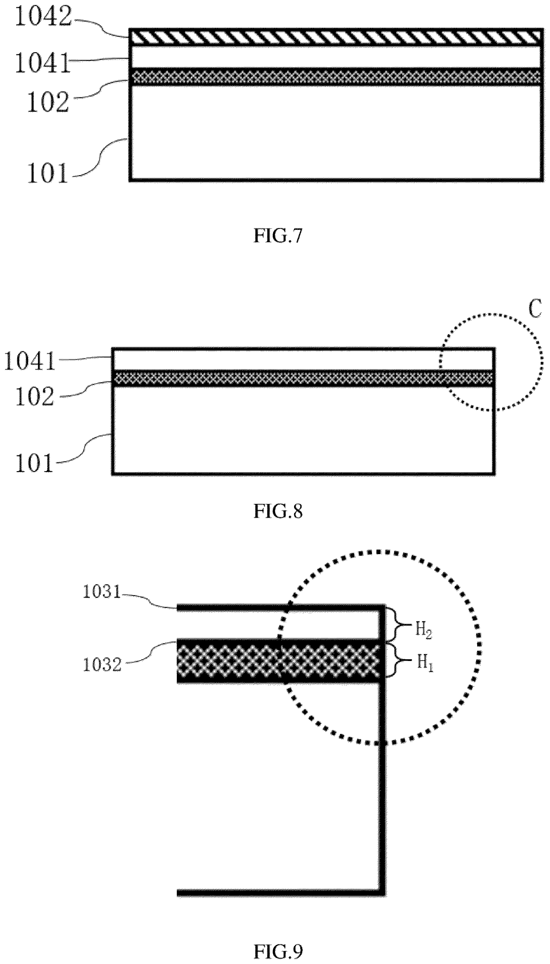

In some embodiments, further referring to FIG.9, the top silicon layer 103 comprises a first surface 1031 and a second surface 1032 arranged facing away from each other along a first direction, the first oxide layer 102 is located on the second surface 1032, the second surface 1032 is connected to the first oxide layer 102, the first surface 1031 and the second surface 1032 have a minimum thickness $H_{min}$ and a maximum thickness $H_{max}$ between them along the first direction, satisfying: $0.1\% \leq (H_{max}-H_{min})/(H_{max}+H_{min}) \leq 5\%$, and $H_{max} > H_2$, $H_{min} < H_2$. Wherein, $(H_{max}-H_{min})/(H_{max}+H_{min})$ is configured to indicate the uniformity of the top silicon layer 103. The first direction specifically refers to the direction indicated by the arrow in FIG.1, it can be understood that the first direction refers to the thickness direction of the top silicon layer 103 respectively.

In some embodiments, the top silicon layer 103 further satisfies: $0.05\mu m \leq H_{max} \leq 0.5\mu m$; $0.03\ \mu m \leq H_{min} \leq 0.3\mu m$. It is understood that the value of $H_{max}$ can be any value within the range of $0.05\mu m$, $0.1\mu m$, $0.2\mu m$, $0.3\mu m$, $0.4\mu m$, or $0.5\mu m$, or any range between any two of these values; the value of $H_{min}$ can be any value within the range of $0.03\mu m$, $0.1\mu m$, $0.15\mu m$, $0.2\mu m$, $0.25\mu m$, or $0.3\mu m$, or any range between any two of these values. When $H_{max}$ and $H_{min}$ meet the above range requirements respectively, it can ensure the uniformity accuracy of the top silicon layer 103 thickness and improve the quality of semiconductor materials.

In some embodiments, the present application also discloses a preparation method for semiconductor materials, comprising:

providing a first substrate 101 and a second substrate 104 respectively, forming a first oxide layer 102 on the first substrate 101 and/or on the second substrate 104;

performing oxygen ion implantation on the second substrate 104 so that the second substrate 104 comprises a first separation layer 1041, a second oxide layer 1042, and a second separation layer 1043 which are in a stacked configuration along the first direction;

bonding the second substrate 104 to the first substrate 101 so that the first oxide layer 102 is located between the first substrate 101 and the second substrate 104;

thinning the second separation layer 1043, the second oxide layer 1042, and a portion of the first separation layer 1041 to form a top silicon layer 103 on the first oxide layer 102, and prepare semiconductor materials.

In some embodiments, in case where forming a first oxide layer 102 on the second substrate 104, the step of performing oxygen ion implantation on the second substrate 104 comprises performing oxygen ion implantation from one side of the second substrate 104 where the first oxide layer 102 is located, the implantated oxygen ions enter the second substrate 104 through the first oxide layer 102. After the formation of the first oxide layer 102 on the second substrate 104, when performing oxygen ion implantation on the second substrate 104, the formed first oxide layer 102 can alleviate the impact on the silicon lattice caused by the oxygen ion implantation, reducing the damage to the second substrate 104 caused by oxygen ion implantation.

In some embodiments, thinning the second separation layer 1043, the second oxide layer 1042, and a portion of the first separation layer 1041 further comprises:

performing a first chemical mechanical polishing on the second separation layer 1043 to expose the second oxide layer 1042;

performing a second chemical mechanical polishing on the second oxide layer 1042 to expose the first separation layer 1041;

performing a third chemical mechanical polishing on the portion of the first separation layer 1041 to form the top silicon layer 103.

In some embodiments, the preparation method of this application achieves an automatic polishing stop process by performing at least three polishing and thinning processes on the second separation layer, the second oxide layer, and the first separation layer. This significantly reduces the occurrence of errors during polishing. The second oxide layer formed by oxygen ion implantation can completely eliminate the errors caused by the first and second polishing, improving the efficiency of the preparation process. It also simplifies the preparation of the top silicon layer, as it only requires consideration of polishing the first separation layer. This significantly enhances the thickness uniformity of the top silicon layer, ensuring the preparation of semiconductor materials with a top silicon layer thickness of less than 500nm.

In some embodiments, the first oxide layer 102 can be formed only on the first substrate 101, and oxygen ion implantation can be directly applied to the second substrate 104, followed by bonding the first substrate 101 and the second substrate 104.

In some embodiments, the first oxide layer 102 can also be formed simultaneously on both the first substrate 101 and the second substrate 104. When the second substrate 104 is bonded to the first substrate 101, the first oxide layer 102 on the first substrate 101 can combine with the first oxide layer 102 on the second substrate 102 to form a complete oxide structure.

It can be understood that the first oxide layer 102 can be a buried oxygen layer in the SOI structure as a semiconductor material, and different methods of forming the first oxide layer 102 can be selected according to the requirements of different thicknesses of the buried oxygen layer; generally, for the convenience of oxygen ion implantation, the thickness of the first oxide layer 102 formed on the second substrate 104 is relatively thin, if a thinner buried oxygen layer is required, the first oxide layer 102 can be formed only on the second substrate 104 during the preparation process; but if a thicker buried oxygen layer is required, the first oxide layer 102 can be formed on the first substrate 101 to increase the thickness of the buried oxygen layer.

In some embodiments, in order to achieve segmented control of chemical mechanical polishing, the first chemical mechanical polishing employs an alkaline slurry with a pH value ranging from 11 to 13; the second chemical mechanical polishing employs an acidic slurry with a pH value ranging from 3 to 5; the third chemical mechanical polishing employs an alkaline slurry with a pH value ranging from 10 to 12. Chemical Mechanical Polishing (CMP) is a technique that combines chemical and mechanical processes to achieve global planarization, the polished surface will undergo a chemical reaction with the polishing slurry used, generating a soft layer which is relatively easy to remove. Then, under the mechanical action of abrasives and polishing pads in the polishing slurry, the soft layer is removed, exposing the surfaces of other layers again before undergoing chemical reaction. The polishing and thinning of the workpiece surface is completed through the alternating process of chemical action and mechanical action.

In some embodiments, in order to further control the process accuracy of chemical mechanical polishing, the polishing temperature for the first chemical mechanical polishing ranges from 20°C to 40°C, the polishing removal rate ranges from $0.5\mu m/min$ to $1\mu m/min$; the polishing temperature for the second chemical mechanical polishing ranges from 20°C to 40°C, the polishing removal rate ranges from $0.1\mu m/min$ to $0.6\mu m/min$; the polishing temperature for the third chemical mechanical polishing ranges from 20°C to 40°C, the polishing removal rate ranges from 60nm/min to 120nm/min.

In some embodiments, before the step of performing a first chemical mechanical polishing on the second separation layer 1043 to expose the second oxide layer 1042, further comprising performing mechanical grinding on the second separation layer 1043, and after the mechanical grinding, the remaining thickness of the second separation layer 1043 ranges from $4\mu m$ to $10\mu m$. Due to the fact that the process of directly using mechanical grinding is simpler and faster than chemical mechanical polishing, mechanical grinding can be used first to improve preparation efficiency, and mechanical polishing after mechanical grinding will not affect the uniformity of the material surface.

In some embodiments, before the step of performing mechanical grinding on the second separation layer 1043, further comprising performing annealing treatment on the second substrate 104 and the first substrate 101, the temperature of the annealing treatment ranges from 1320°C to 1380°C, and the annealing treatment lasts from 6 to 8hours.

In some embodiments, oxygen ion implantation is performed from one side of the first oxide layer 102, in order to avoid the impact of ion implantation on the quality of the second substrate 104, it is necessary to accurately set the process parameters of ion implantation, in actual processes, product quality is ensured by controlling the angle of oxygen ion implantation, the energy of the oxygen ions, and the dose of implantation, oxygen ion implantation is achieved through ion implantation machines. Wherein, the energy of the oxygen ion implantation ranges from 100keV to 500keV, the dose of implantation ranges from $7E16cm^{-2}$ to $2E19cm^{-2}$, the angle of oxygen ion implantation ranges from 6° to 8°, the ion implantation temperature is greater than or equal to 300°C, and the oxygen ion beam current is greater than or equal to 10mA. When the above process parameters are met, defects generated by the second substrate 104 and the first oxide layer 102 can be reduced or even avoided while ensuring the quality of the second oxide layer 1042. Preferably, the energy of the oxygen ion implantation ranges from 150keV to 250keV, the dose of implantation ranges from $8E16cm^{-2}$ to $1E19cm^{-2}$, the angle of oxygen ion implantation ranges from 6° to 8°, the ion implantation temperature is greater than or equal to 500°C, and the oxygen ion beam current is greater than or equal to 15mA. According to appropriate process conditions, the impact caused by the ion implantation can be minimized.

In some embodiments, by utilizing oxygen ion implantation, a uniformly distributed ion implantation layer is generated, which forms the second oxide layer 1042 during the annealing process. The second oxide layer 1042 serves as a barrier layer for chemical mechanical polishing, allowing for good control over the thickness and uniformity of the top silicon layer 103 before the final chemical mechanical polishing process. The uniformity of the top silicon layer 103 is controlled by the oxygen ion implantation process, so the uniformity of the top silicon layer 103 is very good; and according to different oxygen ion implantation processes, the thickness of the second oxide layer 1042 can be adjusted freely.

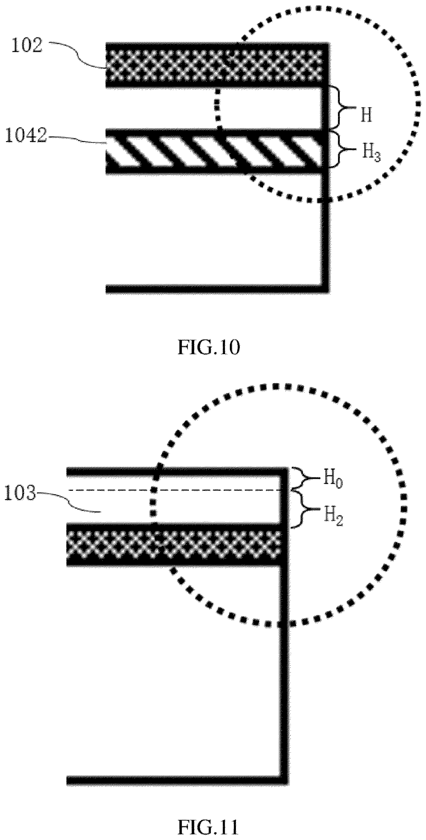

In some embodiments, further referring to FIG.10 and FIG.11, the second oxide layer 1042 has an average thickness $H_3$ along the first direction, the distance between the second oxide layer 1042 and the first oxide layer 102 in the first direction is H, the size the first separation layer 1041 is thinned in the first direction is $H_0$, further satisfying:

$H_2+H_0\leq H$, and $100nm\leq H_3\leq 400nm$, $50nm\leq H_0\leq 300nm$. Wherein, the first direction specifically refers to the direction indicated by the arrow in FIG.1, it can be understood that the first direction refers to the thickness direction of the second oxide layer 1042, the first oxide layer 102, and the first separation layer 1041 respectively, considering that there may be some operational errors during the actual polishing process, $H_2+H_0\leq H$.

In some embodiments, the material of the first separation layer 1041 and the second separation layer 1043 is silicon, the material of the second oxide layer 1042 is silica.

In some embodiments, this application further provides a semiconductor device, the semiconductor device comprises the aforementioned semiconductor material, the semiconductor device comprises silicon-on-insulator power devices.

Embodiment one

FIG.2 to FIG.9 shows a preparation process of a semiconductor material.

Refer to FIG.2 and FIG.3, which respectively provide the first substrate 101 and the second substrate 104, after the oxidation treatment of the surface of the second substrate 104, the first oxide layer 102 is formed; wherein, the second substrate 104 uses either a conventional Czochralski single crystal MCZ or a floating zone single crystal FZ substrate wafer. The substrate wafer is a perfect single crystal substrate wafer without any native particle defects, with a maximum of 10 particles of diameter 0.12 $\mu$m; the first oxide layer 102 is a thermal oxide layer formed by dry oxygen oxidation or wet oxygen oxidation, the thickness of its oxide layer is between 10 and 200nm, and its breakdown voltage resistance performance is equal to or greater than 9MV/cm; the first substrate 101 uses either a conventional Czochralski single crystal MCZ or a floating zone single crystal FZ substrate wafer, the substrate wafer is a perfect single crystal substrate wafer without any native particle defects.

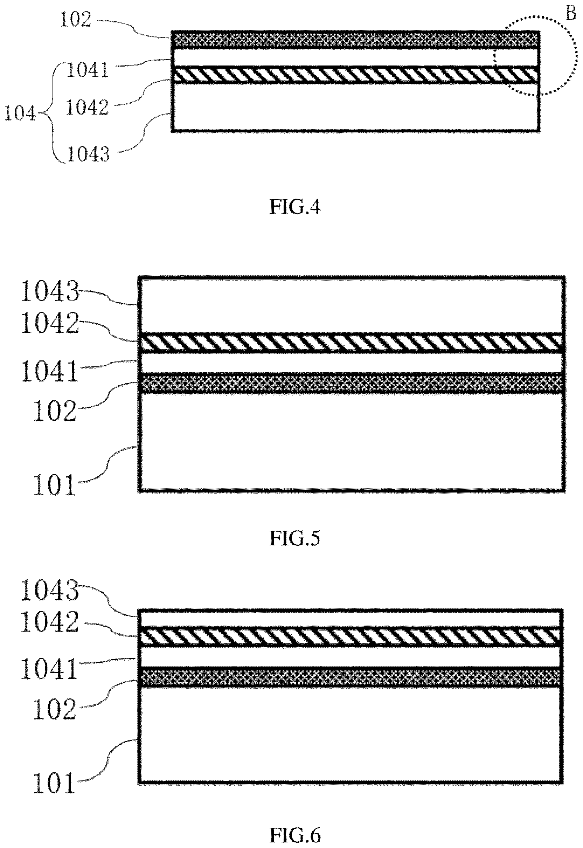

Referring to FIG.4, oxygen ion implantation is performed on the second substrate 104 along one side of the first oxide layer 102, so that the second substrate 104 comprises a first separation layer 1041, a second oxide layer 1042, and a second separation layer 1043 which are in a stacked configuration along the first direction; wherein, the material of the first oxide layer 102 and the second oxide layer 1042 is silica, the material of the first separation layer 1041 and the second separation layer 1043 is silicon. In order to form a relatively continuous second oxide layer 1042, the energy of the oxygen ions is 200kev, the oxygen ion beam current ranges from 40mA to 50mA, the dose of implantation is $4E17cm^{-2}$, the angle of oxygen ion implantation is 7°, the ion implantation temperature is 500°C.

Referring to FIG.5, the second substrate 104 is bonded to the first substrate 101 to connect the first oxide layer 102 with the first substrate 101, subsequently, an annealing process is conducted, in order to increase the bonding strength, activate the oxygen ions in the first oxide layer 102 of the second substrate 104, and repair the damaged layer, the annealing temperature after bonding ranges from 1340°C to 1360°C, with a preferred temperature of 1350°C. The annealing time is 7 hours.

Referring to FIG.6, the second separation layer 1043 is thinned through mechanical grinding to achieve the target thickness. In mechanical grinding, a coarse grinding wheel with a grit size of 800 or less is first used for initial grinding, and then a fine grinding wheel with a grit size of 4000 or more is used for a second grinding, after the mechanical grinding, the remaining thickness of the second separation layer 1043 ranges from $4\mu$m to $10\mu$m.

Referring to FIG.7, perform a first chemical mechanical polishing on the second separation layer 1043 to expose the second oxide layer 1042, after polishing the surface of the second oxide layer 1042 using an alkaline polishing slurry, the process automatically stops. The polishing employs an alkaline slurry with a pH value ranging from 11 to 12, the particle diameter in the slurry is less than 60nm, the polishing temperature is 30°C, the polishing removal rate ranges from $0.7\mu$m/min to $0.8\mu$m/min; when polishing to the second oxide layer 1042, because the alkaline slurry only removes silicon and does not remove silica, polishing will automatically stop on the surface of the second oxide layer 1042.

Referring to FIG.8, perform a second chemical mechanical polishing on the second oxide layer 1042 to expose the first separation layer 1041, the polishing employs an acidic slurry with a pH value ranging from 3 to 4, the particle diameter in the slurry is less than 50nm, the polishing temperature is 30°C, the polishing removal rate ranges from $0.3\mu$m/min to $0.4\mu$m/min, when polishing to the interface between the second oxide layer 1042 and the first separation zone, because the acidic slurry only removes silica and does not remove silicon, polishing will automatically stop at the first separation layer 1041.

Referring to FIG.1 and FIG.11, perform a third chemical mechanical polishing on the portion of the first separation layer 1041 to form the top silicon layer 103; the surface roughness and particle condition can be improved by the third chemical mechanical polishing, and semiconductor materials with excellent uniformity are obtained. Specifically: the third chemical mechanical polishing employs an alkaline slurry with a pH value ranging from 11 to 12, the particle diameter in the slurry is less than 40nm, the polishing temperature is 30°C, the polishing removal amount ranges from 50nm to 300nm, the polishing removal amount can be understood as the height of the first separation zone removed in the first direction, which is the thinning size $H_0$ of the first separation layer 1041 in the first direction; the polishing removal rate ranges from 80nm/min to 100nm/min, based on the aforementioned process steps, a semiconductor material can be obtained with a top silicon layer 103 thickness less than 200nm, intra-wafer film thickness deviation less than $\pm$10nm, and thickness non-uniformity (RTG) less than 5%.

Embodiment two

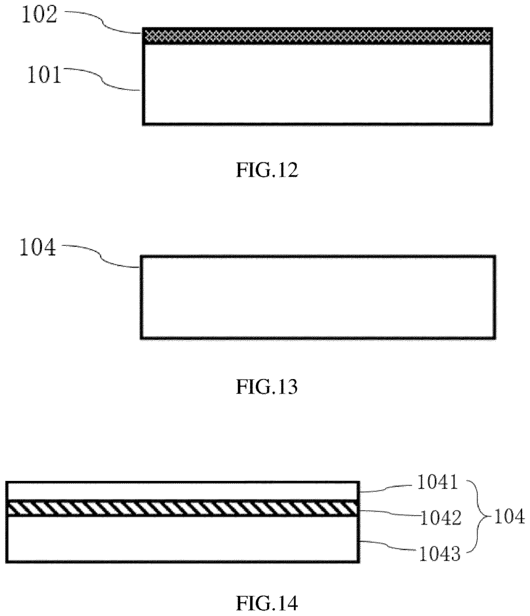

The specific process steps are the same as in embodiment one, except that the structures of the first substrate 101 and the second substrate 104 provided are different. Referring to FIG.12, 13, and 14, after oxidizing the surface of the first substrate 101, a first oxide layer 102 is formed. However, no oxide layer is set on the second substrate 104, and direct oxygen ion implantation is performed on the second substrate 104. The bonded structure is the same as shown in FIG.5.

Embodiment three

The specific process steps are the same as in embodiment one, except that a first oxide layer 102 is formed on both the first substrate 101 and the second substrate 104, the structures are referenced to as shown in FIG.3 and FIG.12 respectively. The structure obtained after bonding the first substrate 101 and the second substrate 104 is similar to that shown in Figure 5.

Comparative embodiment

Compared to the preparation method of this embodiment, in the comparative embodiment, the process step of oxygen ion implantation to form an oxide layer is not used. Instead, the first substrate 101 is directly bonded with the second substrate 104 containing an oxide layer, followed by annealing and thinning to obtain a semiconductor material with a structure similar to FIG.1.

Table 1 provides the comparative test data for the semiconductor material prepared by the aforementioned preparation method and the semiconductor material of the comparative embodiment. The formula for calculating non-uniformity is as follows: non-uniformity=$(H_{max}-H_{min})/(H_{max}+H_{min})$.

Table 1

|  | $H_{max}$ nm | $H_{min}$ nm | non-uniformity |
|---|---|---|---|
| Embodiment 1 | 149.15nm | 138.45nm | 3.71% |
| Comparative embodiment | 2.56$\mu$m | 1.88$\mu$m | 15.31% |

As shown in Table 1, the preparation method disclosed in this application allows for specific chemical mechanical polishing processes targeting different layer structures generated by oxygen ion implantation. By employing selective polishing, layer transfer is achieved, and a final multilayer structure semiconductor material can be obtained. This approach significantly reduces the thickness and non-uniformity on the surface of the top silicon layer 103. Therefore, selective polishing can greatly mitigate the non-uniformity errors caused by the longer duration of direct polishing in the comparative example. It effectively avoids the problem of non-uniformity in the top silicon layer 103 that can be caused by direct polishing, thereby greatly improving the thickness uniformity of the top silicon layer 103. This provides a guarantee for the preparation of semiconductor materials with a top silicon layer 103 thickness less than 500nm. In addition, by setting the first oxide layer 102 on the second substrate 104, further mitigation of the damage caused by oxygen ion implantation on the second substrate 104 can be achieved, thereby improving the overall quality of the material.

The above-disclosed embodiments provide a detailed description of a semiconductor material, preparation method, and semiconductor device of the present application. Specific examples are applied in this application to illustrate the principles and implementation methods. It should be noted that the explanations provided in the above embodiments are only intended to facilitate understanding of the technical solutions and the core ideas of the present application; Those skilled in the art should understand that they can still modify the technical solutions described in the above embodiments or make equivalent replacements for some technical features. However, these modifications or replacements do not depart from the essence of the technical solutions of the embodiments disclosed in this application.

**Claims**

1. A semiconductor material, wherein, the semiconductor material comprises: a first substrate (101), a first oxide layer (102), and a top silicon layer (103) which are in a stacked configuration; the first oxide layer (102) is located on the substrate (101), and the top silicon layer (103) is located on one side of the first oxide layer (102) away from the first substrate (101);

wherein, the first oxide layer (102) has an average thickness $H_1$ along a first direction, the top silicon layer (103) has an average thickness $H_2$ along the first direction, satisfying:

$$0.01 \leq H_2/H_1 \leq 100, \text{ and } 0.01\mu m \leq H_1 \leq 5\mu m, 0.01\mu m \leq H_2 \leq 0.5\mu m.$$

2. The semiconductor material according to claim 1, wherein, the top silicon layer (103) comprises a first surface (1031) and a second surface (1032) arranged facing away from each other along a first direction, the first oxide layer (102) is located on the second surface (1032), the first surface (1031) and the second surface (1032) have a minimum thickness $H_{min}$ and a maximum thickness $H_{max}$ therebetween along the first direction, satisfying:

$$0.1\% \leq (H_{max}-H_{min})/(H_{max}+H_{min}) \leq 5\%, \text{ and } H_{max} > H_2, H_{min} < H_2.$$

3. The semiconductor material according to claim 2, wherein, the top silicon layer (103) satisfies:

$$0.05\mu m \leq H_{max} \leq 0.5\mu m;$$

and/or,

$$0.03\mu m \leq H_{min} \leq 0.3\mu m.$$

4. A preparation method for a semiconductor material, wherein the method comprises the steps of:

   providing a first substrate (101) and a second substrate (104) respectively, forming a first oxide layer (102) on the first substrate (101) and/or on the second substrate (104);
   performing oxygen ion implantation on the second substrate (104) so that the second substrate (104) comprises a first separation layer (1041), a second oxide layer (1042), and a second separation layer (1043) which are in a stacked configuration along the first direction;
   bonding the second substrate (104) to the first substrate (101) so that the first oxide layer (102) is located between the first substrate (101) and the second substrate (104);
   thinning the second separation layer (1043), the second oxide layer (1042), and a portion of the first separation layer (1041) to form a top silicon layer (103) on the first oxide layer (102), and acquire the semiconductor material.

5. The preparation method for a semiconductor material according to claim 4, wherein, in case where the first oxide layer (102) is formed on the second substrate (104), the step of performing oxygen ion implantation on the second substrate (104) comprises performing oxygen ion implantation from one side of the second substrate (104) where the first oxide layer (102) is located.

6. The preparation method for a semiconductor material according to any one of claim 4 to claim 5, wherein, thinning the second separation layer (1043), the second oxide layer (1042), and a portion of the first separation layer (1041) comprises:

   performing a first chemical mechanical polishing on the second separation layer (1043) to expose the second oxide layer (1042);
   performing a second chemical mechanical polishing on the second oxide layer (1042) to expose the first separation layer (1041);
   performing a third chemical mechanical polishing on a portion of the first separation layer (1041) to form the top silicon layer (103).

7. The preparation method for a semiconductor material according to claim 6, wherein, the first chemical mechanical polishing employs an alkaline slurry with a pH value ranging from 11 to 13; the second chemical mechanical polishing employs an acidic slurry with a pH value ranging from 3 to 5; the third chemical mechanical polishing employs an alkaline slurry with a pH value ranging from 10 to 12.

8. The preparation method for a semiconductor material according to any one of claim 6-7, wherein, the polishing temperature for the first chemical mechanical polishing ranges from 20°C to 40°C, the polishing removal rate ranges from $0.5\mu m/min$ to $1\mu m/min$; the polishing temperature for the second chemical mechanical polishing ranges from 20°C to 40°C, the polishing removal rate ranges from $0.1\mu m/min$ to $0.6\mu m/min$; the polishing temperature for the third chemical mechanical polishing ranges from 20°C to 40°C, the polishing removal rate ranges from 60nm/min to 120nm/min.

9. The preparation method for a semiconductor material according to claim 6, wherein, before the step of performing a first chemical mechanical polishing on the second separation layer (1043) to expose the second oxide layer (1042), further comprising: performing mechanical grinding on the second separation layer (1043), and after the mechanical grinding, the remaining thickness of the second separation layer (1043) ranges from $4\mu m$ to $10\mu m$.

10. The preparation method for a semiconductor material according to claim 9, wherein, before the step of performing mechanical grinding on the second separation layer (1043), further comprising performing annealing treatment on the second substrate (104) and the first substrate (101), the temperature of the annealing treatment ranges from 1320°C to 1380°C, and the annealing treatment lasts from 6 to 8hours.

11. The preparation method for a semiconductor material according to any one of claim 4 to claim 10, wherein, during the oxygen ion implantation, the energy of the oxygen ion implantation ranges from 100keV to 500keV, the dose of implantation ranges from $7E16cm^{-2}$ to $2E19cm^{-2}$, the angle of oxygen ion implantation ranges from 6° to 8°, the ion implantation temperature is greater than or equal to 300°C, and the oxygen ion beam current is greater than or equal to 10mA.

12. The preparation method for a semiconductor material according to claim 9, wherein, the first oxide layer (102) has an average thickness $H_1$ along the first direction, the top silicon layer (103) has an average thickness $H_2$ along the first direction, satisfying:

$$0.01 \leq H_2/H_1 \leq 100, \text{ and } 0.01\mu m \leq H_1 \leq 5\mu m, 0.01\mu m \leq H_2 \leq 0.5\mu m.$$

13. The preparation method for a semiconductor material according to claim 12, wherein, the second oxide layer (1042) has an average thickness $H_3$ along the first direction, the distance between the second oxide layer (1042) and the first oxide layer (102) in the first direction is H, the size the first separation layer (1041) is thinned in the first direction is $H_0$, satisfying:

$$H_2 + H_0 \leq H, \text{ and } 100nm \leq H_3 \leq 400nm, 50nm \leq H_0 \leq 300nm.$$

14. The preparation method for a semiconductor material according to any one of claim 4 to claim 13, wherein, the material of the first separation layer (1041) and the second separation layer (1043) is silicon, the material of the second oxide layer (1042) is silica.

15. A semiconductor device, wherein, the semiconductor device comprises a semiconductor material according to any one of claim 1 to claim 3; or the semiconductor device comprises a semiconductor material obtained by a preparation method for a semiconductor material according to any one of claim 4 to claim 14.

103

102

101

A

FIG.1

101

FIG.2

102

104

FIG.3

FIG.4

FIG.5

FIG.6

FIG.7

FIG.8

FIG.9

102

1042

H

H₃

FIG.10

103

H₀

H₂

FIG.11

102

101

FIG.12

104

FIG.13

1041
1042
1043
104

FIG.14

<div align="center">**INTERNATIONAL SEARCH REPORT**</div>

| | International application No. |
|---|---|
| | **PCT/CN2022/143559** |

**A. CLASSIFICATION OF SUBJECT MATTER**

H01L21/762(2006.01)i;H01L21/306(2006.01)i;H01L21/3105(2006.01)i

According to International Patent Classification (IPC) or to both national classification and IPC

**B. FIELDS SEARCHED**

Minimum documentation searched (classification system followed by classification symbols)

IPC：H01L

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 绝缘体上硅, 键合, 氧, 离子, 注入, 减薄, 化学机械抛光, 平坦化, SOI, silicon on insulator, bonding, oxygen, ion?, implant, thinning, CMP, chemical mechanical polishing

**C. DOCUMENTS CONSIDERED TO BE RELEVANT**

| Category* | Citation of document, with indication, where appropriate, of the relevant passages | Relevant to claim No. |
|---|---|---|
| X | CN 101101891 A (SHANGHAI SIMGUI TECHNOLOGY CO., LTD. et al.) 09 January 2008 (2008-01-09)<br>description, page 9, line 11 to page 18, line 7, and figures 2A-2I | 1, 4-5, 11, 14-15 |
| Y | CN 101101891 A (SHANGHAI SIMGUI TECHNOLOGY CO., LTD. et al.) 09 January 2008 (2008-01-09)<br>description, page 9, line 11 to page 18, line 7, and figures 2A-2I | 2-3, 6-10, 12-13 |
| Y | CN 114843290 A (BEIJING SEETRUM TECHNOLOGY CO., LTD.) 02 August 2022 (2022-08-02)<br>description, paragraphs [0069]-[0147], and figure 6 | 2-3, 6-10, 12-13 |
| X | CN 113053919 A (XIAMEN JINGWEI PRECISION TECHNOLOGY CO., LTD.) 29 June 2021 (2021-06-29)<br>description, paragraphs [0004]-[0062], and figures 1-8 | 1, 15 |
| X | CN 101604657 A (SHANGHAI SIMGUI TECHNOLOGY CO., LTD. et al.) 16 December 2009 (2009-12-16)<br>description, page 2, line 4 to page 7, line 16, and figures 1-9 | 4-5, 11, 14-15 |

☑ Further documents are listed in the continuation of Box C.    ☑ See patent family annex.

| | |
|---|---|
| \* Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **15 May 2023** | **23 May 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

International application No.

**PCT/CN2022/143559**

### C. DOCUMENTS CONSIDERED TO BE RELEVANT

| Category* | Citation of document, with indication, where appropriate, of the relevant passages | Relevant to claim No. |
|---|---|---|
| A | JP 2001110739 A (SUMITOMO METAL INDUSTRIES, LTD.) 20 April 2001 (2001-04-20) entire document | 1-15 |

Form PCT/ISA/210 (second sheet) (July 2022)

**INTERNATIONAL SEARCH REPORT**
Information on patent family members

International application No.

**PCT/CN2022/143559**

| Patent document cited in search report | | | Publication date (day/month/year) | Patent family member(s) | | | Publication date (day/month/year) |
|---|---|---|---|---|---|---|---|
| CN | 101101891 | A | 09 January 2008 | None | | | |
| CN | 114843290 | A | 02 August 2022 | CN | 114843294 | A | 02 August 2022 |
| | | | | WO | 2022161427 | A1 | 04 August 2022 |
| CN | 113053919 | A | 29 June 2021 | None | | | |
| CN | 101604657 | A | 16 December 2009 | CN | 101604657 | B | 09 February 2011 |
| JP | 2001110739 | A | 20 April 2001 | JP | 4370647 | B2 | 25 November 2009 |

Form PCT/ISA/210 (patent family annex) (July 2022)

**EP 4 439 639 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211652486